# EUROPÄISCHE PATENTSCHRIFT

(11) **EP 3 147 607 B1**
(45) Veröffentlichungstag und Bekanntmachung des Hinweises auf die Patenterteilung: **22.04.2020**
(21) Anmeldenummer: 15002734.0
(22) Anmeldetag: 22.09.2015
(51) Int. Cl.: F25D 23/06, F25D 25/02, F25D 27/00

(54) **EINLEGEBODEN-BAUGRUPPE FÜR EIN KÜHL- ODER GEFRIERGERÄT**
SHELF ASSEMBLY FOR A REFRIGERATOR OR FREEZER
MODULE D'ÉTAGÈRE POUR REFRIGERATEUR OU CONGÉLATEUR

(43) Veröffentlichungstag der Anmeldung: 29.03.2017
(73) Patentinhaber: emz-Hanauer GmbH & Co. KGaA, 92507 Nabburg (DE)
(72) Erfinder: Schenkl, Johann, 92439 Bodenwöhr (DE); Signorino, Manfredi, 92507 Nabburg (DE); Spießl, Georg, 92540 Willhof-Altendorf (DE); Wilhelm, Georg, 92543 Guteneck (DE)
(74) Vertreter: Katérle, Axel

(56) Entgegenhaltungen:
- WO-A1-2014/205352
- DE-A1-102007 020 882
- DE-A1-102009 040 830
- US-A- 5 034 861
- US-A1- 2015 216 062

## Beschreibung

Die vorliegende Erfindung befasst sich mit einer Einlegeboden-Baugruppe für ein Kühl- oder Gefriergerät.

Hinsichtlich des Standes der Technik zu derartigen Einlegeboden-Baugruppen wird beispielhaft auf die US 2014/0376213 A1, US 2014/0217879 A1, US 8,322,873 B2, US 8,899,704 B2 und US 8,596,205 B2 verwiesen.

Eine Einlegeboden-Baugruppe im Sinne der vorliegenden Erfindung weist eine Abstellplatte zum Abstellen von Gegenständen, eine mit der Abstellplatte zu einer Baueinheit zusammengefügte Halterungsanordnung sowie einen oder mehrere elektrische Verbraucher auf, beispielsweise ein Leuchtmodul, mittels dessen Licht erzeugt werden kann, das beispielsweise zur Illumination der Abstellplatte oder/und eines Innenraums des Kühl- oder Gefriergeräts dienen kann. Andere elektrische Verbraucher umfassen beispielsweise einen Lüfter, eine Kamera oder/und einen Sensor (z.B. Temperatursensor). Eine derartige Einlegeboden-Baugruppe kann vermittels der Halterungsanordnung in dem Innenraum des Kühl- oder Gefriergeräts aufgehängt werden, wobei häufig die Höhenposition wählbar ist, d.h. der Nutzer kann zwischen verschiedenen Höhenpositionen für die Einlegeboden-Baugruppe in dem Innenraum wählen. Die Einlegeboden-Baugruppe ist als solche, d.h. als Baugruppe einschließlich der Abstellplatte, der Halterungsanordnung und des mindestens einen elektrischen Verbrauchers, in den Innenraum einsetzbar und aus diesem herausnehmbar.

Die Halterungsanordnung umfasst bei der im Rahmen der vorliegenden Erfindung betrachteten Einlegeboden-Baugruppe mindestens ein im Bereich eines Seitenrands der Abstellplatte angeordnetes Halterungselement, welches sich längs des Seitenrands erstreckt und zumindest teilweise aus einem elektrisch leitenden Metallwerkstoff gefertigt ist. Als Seitenrand wird hier ein solcher Plattenrand bezeichnet, der aus der Perspektive eines Nutzers, der vor dem Kühl- oder Gefriergerät steht und in den Innenraum des Geräts hineinsieht, auf der rechten oder linken Seite der Abstellplatte verläuft. Beide Seitenränder (d.h. rechts und links) werden bei dieser Betrachtungsweise durch einen dem Nutzer nahen vorderen Plattenrand sowie einen vom Nutzer entfernten hinteren Plattenrand ergänzt.

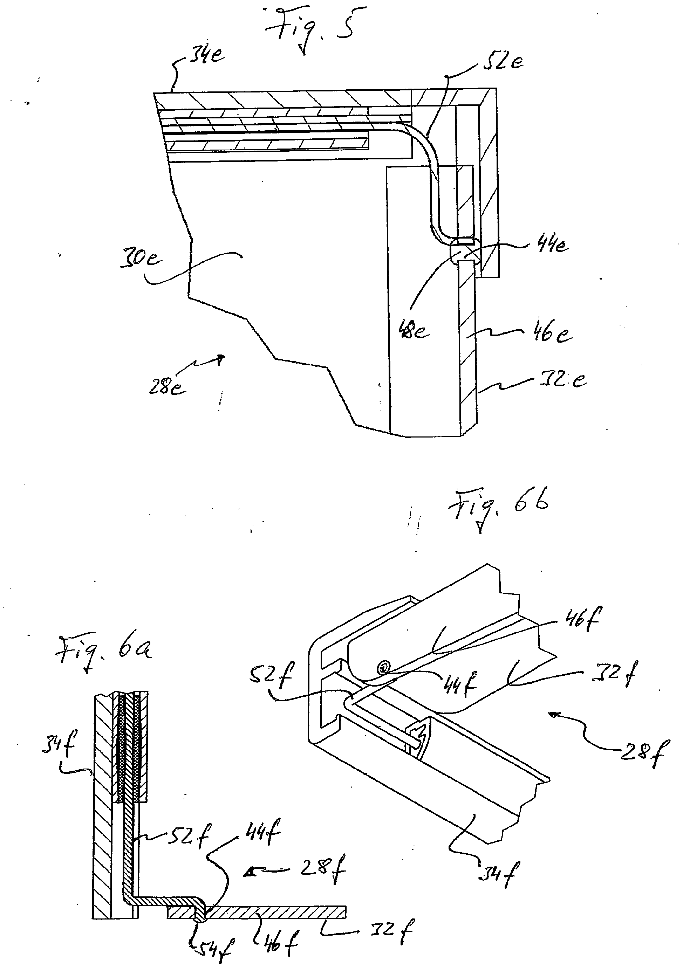

Der elektrisch leitende Metallwerkstoff des Halterungselements kann zur Stromleitung genutzt werden, um über das Halterungselement den mindestens einen elektrischen Verbraucher der Einlegeboden-Baugruppe mit elektrischer Energie zu versorgen. Auf die Möglichkeit, ein metallisches Halterungselement einer Einlegeboden-Baugruppe zur Stromleitung zu nutzen, wird beispielsweise in der US 2014/0376213 A1 hingewiesen. Zur Kontaktierung des Halterungselements mit einem im Stromversorgungskreis benachbarten elektrischen Leiter wird dort vorgeschlagen, eine Isolierbeschichtung des Halterungselements lokal zu entfernen und in den derart freigelegten metallischen Oberflächenbereichen eine elektrische Kontaktierung herzustellen, siehe beispielweise die Abschnitte [0024] und [0035] der US 2014/0376213 A1. Auch in der US 5,034,861 wird die Nutzung von seitlichen Tragarmen, zwischen denen eine Ablageplatte für einen Kühlschrank eingefasst ist, zur elektrischen Stromleitung zu einer unter der Ablageplatte angeordneten Leuchte im Rahmen des Ausführungsbeispiels der Figuren 6, 6A, 6B offenbart.

Die vorliegende Erfindung geht davon aus, dass das Halterungselement einen Metallkern aufweist, der eine Beschichtung oder Umhüllung aus einem elektrisch isolierenden Material aufweist und schlägt in Übereinstimmung mit dem Anspruch 1 vor, dass ein elektrisch leitendes Element in einen in das Halterungselement eingebrachten, die Beschichtung oder Umhüllung durchdringenden Ausschnitt in dem Halterungselement hineinragt und dort in elektrisch leitendem Kontakt mit dem Metallkern des Halterungselements steht. Dabei bestehen verschiedene Realisierungsmöglichkeiten zur Herstellung des elektrisch leitenden Kontakts zwischen dem Halterungselement und dem elektrisch leitenden Element innerhalb des Ausschnitts. Gemäß einer möglichen Ausgestaltung ist das elektrisch leitende Element ein in den Ausschnitt eingesetzter Bolzenkörper mit einem aus dem Ausschnitt herausstehenden Bolzenkopf, wobei der elektrisch leitende Kontakt in diesem Fall zwischen einer Innenwand des Ausschnitts und einem innerhalb des Ausschnitts befindlichen Teil einer Außenumfangsfläche des Bolzenkörpers realisiert sein kann. Ein weiteres in dem Stromversorgungspfad liegendes elektrisch leitendes Element kann dann außerhalb des Ausschnitts auf dem Bolzenkopf aufliegen, gewünschtenfalls unter Federvorspannung, oder es kann zwischen dem Halterungselement und dem Bolzenkopf eingeklemmt sein. Der Bolzenkörper kann beispielweise ein Niet oder eine Schraube sein.

Gemäß einer anderen möglichen Ausgestaltung ist das elektrisch leitende Element durch Quetscheingriff in dem Ausschnitt gehalten. Das elektrisch leitende Element kann beispielweise zwischen gegenüberliegenden Abschnitten einer Innenwand des Ausschnitts eingequetscht sein oder es kann zwischen der Innenwand des Ausschnitts und einem in den Ausschnitt eingesetzten, insbesondere elektrisch leitenden Bolzenkörper eingequetscht sein. Der Bolzenkörper kann seinerseits beispielsweise ein Niet oder eine Schraube sein.

Das elektrisch leitende Element ist bei bestimmten Ausführungsformen ein Drahtstück. Dieses Drahtstück kann durch den Ausschnitt hindurchreichen und im Bereich eines aus dem Ausschnitt herausstehenden Endabschnitts zu einem Nietkopf geformt sein. Alternativ oder zusätzlich kann ein derartiges Drahtstück in dem Ausschnitt des Halterungselements verquetscht sein, um einen elektrisch leitenden Kontakt zwischen dem Metallwerkstoff des Halterungselements und dem Drahtstück herzustellen.

Der Ausschnitt kann als Sack- oder Durchgangsloch mit Kreisquerschnitt ausgeführt sein. Bei anderen Ausführungsformen besitzt der Ausschnitt hingegen Schlitzform.

Für den Metallwerkstoff des Halterungselements eignet sich beispielweise Aluminium, Eisen oder Stahl. Der Stahl kann unlegiert oder niedriglegiert sein. Als niedriglegiert wird ein Stahl üblicherweise bezeichnet, wenn keine seiner Legierungskomponenten einen Massenanteil von 5 % oder mehr besitzt. Auf die Verwendung eines hochlegierten Stahls für das Halterungselement kann zumindest bei bestimmten Ausführungsformen der vorliegenden Erfindung verzichtet werden.

Der elektrische Verbraucher ist beispielsweise im Bereich eines Vorderrands der Abstellplatte montiert. Das elektrisch leitende Element kann in diesem Fall (aber nicht nur in diesem Fall) in dem Stromversorgungspfad zwischen dem Halterungselement und dem Verbraucher liegen. Es ist im Rahmen der Erfindung aber keineswegs ausgeschlossen, die hier offenbarte Kontaktierungstechnik für ein elektrisch leitendes Element anzuwenden, das im Stromversorgungspfad des mindestens einen elektrischen Verbrauchers zwischen dem Halterungselement und einer an einer Innenraum-Begrenzungswand des Kühl- oder Gefriergeräts angeordneten elektrischen Stromspeisestelle liegt.

Die vorliegende Erfindung stellt desweiteren ein Verfahren zur Herstellung einer Einlegeboden-Baugruppe der vorstehend beschriebenen Art bereit, in Übereinstimmung mit dem Anspruch 11. Gemäß diesem Verfahren wird der Ausschnitt durch Bohren oder Stanzen eines Vorprodukts des Halterungselements gebildet. Das Vorprodukt umfasst einen Metallkern, der beispielweise aus einem Blechmaterial gebildet ist, sowie eine

Beschichtung oder Umhüllung aus einem elektrisch isolierenden Material, wobei zur Bildung des Ausschnitts durch die Beschichtung oder Umhüllung hindurch in den Metallkern hinein und gewünschtenfalls durch diesen hindurch gebohrt oder gestanzt wird. Ein derartiger Bohr- oder Stanzvorgang kann mit vergleichsweise geringem Aufwand ausgeführt werden. Daher eignet sich die geschilderte Verfahrensweise für eine kostengünstige Produktion im Rahmen einer Massenfertigung.

Die Beschichtung oder Umhüllung des Metallkerns umfasst beispielsweise eine Eloxal-Beschichtung, eine Pulverlackierung oder eine Kunststoffeinbettung des Metallkerns. Die Eloxal-Beschichtung kann bei einem Aluminiumkern des Halterungselements durch Eloxieren erzeugt werden. Die Pulverlackierung kann beispielsweise bei einem Eisen- oder Stahlkern in einem Pulverbeschichtungsverfahren erzeugt werden. Eine Kunststoffeinbettung kann beispielsweise durch Umspritzen des Metallkerns mit einem Kunststoffmaterial realisiert werden.

Die Erfindung wird nachfolgend anhand der beigefügten Zeichnungen weiter erläutert. Es stellen dar:
Figur 1 eine Perspektivansicht auf ein Kühl- oder Gefriergerät gemäß einem Ausführungsbeispiel bei geöffneter Gerätetür,
Figur 2 in einer Perspektivdarstellung einen Ausschnitt einer Einlegeboden-Baugruppe für das Kühl- oder Gefriergerät der Figur 1 gemäß einem Ausführungsbeispiel;
Figur 3 in einer Perspektivdarstellung einen Ausschnitt einer Einlegeboden-Baugruppe gemäß einer Variante zu dem Ausführungsbeispiel der Figur 2,
Figuren 4a, 4b zwei Varianten eines ersten Ausführungsbeispiels zur elektrischen Kontaktierung eines Halterungselements einer Einlegeboden-Baugruppe für ein Kühl- oder Gefriergerät,
Figur 5 ein zweites Ausführungsbeispiel zur elektrischen Kontaktierung eines Halterungselements einer Einlegeboden-Baugruppe für ein Kühl- oder Gefriergerät,
Figuren 6a, 6b eine Schnitt- bzw. eine Perspektivansicht eines dritten Ausführungsbeispiels zur elektrischen Kontaktierung eines Halterungselements einer Einlegeboden-Baugruppe für ein Kühl- oder Gefriergerät,
Figuren 7a, 7b eine Schnitt- bzw. eine Perspektivansicht eines vierten Ausführungsbeispiels zur elektrischen Kontaktierung eines Halterungselements einer Einlegeboden-Baugruppe eines Kühl- oder Gefriergeräts,
Figuren 8a bis 8d verschiedene Ansichten eines fünften Ausführungsbeispiels zur elektrischen Kontaktierung eines Halterungselements einer Einlegeboden-Baugruppe eines Kühl- oder Gefriergeräts, und
Figuren 9a bis 9d verschiedene Ansichten eines sechsten Ausführungsbeispiels zur elektrischen Kontaktierung eines Halterungselements einer Einlegeboden-Baugruppe eines Kühl- oder Gefriergeräts.

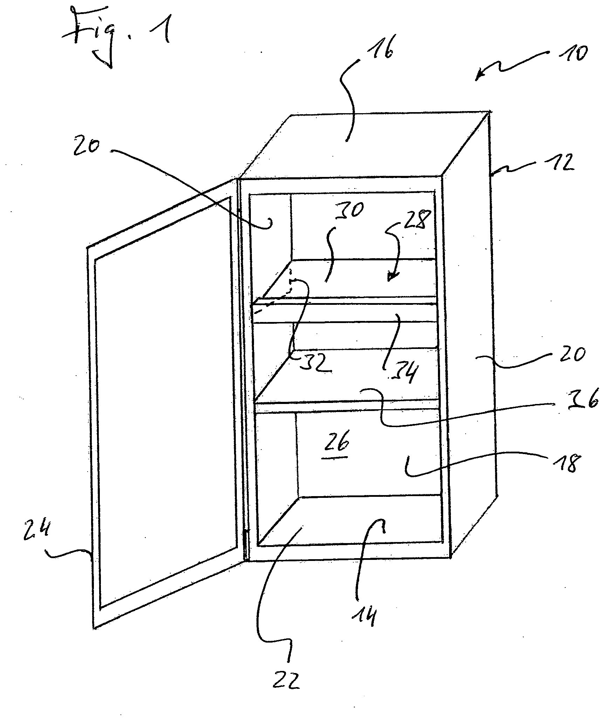

Es wird zunächst auf Figur 1 verwiesen. Das dort dargestellte Kühl- oder Gefriergerät ist allgemein mit 10 bezeichnet. Es handelt sich um ein Gerät in Schrankbauweise, das zur kühlen oder gefrorenen Aufbewahrung von Lebensmitteln dient und einen Schrankkorpus 12 mit einer Bodenwand 14, einer Deckwand 16, einer Rückwand 18 sowie zwei Seitenwänden 20 aufweist. Der Schrankkorpus 12 bildet eine von der Bodenwand 14, der Deckwand 16 und den beiden Seitenwänden 20 umrandete Zugangsöffnung 22, welche durch eine an einer der Seitenwände 20 um eine vertikale Schwenkachse schwenkbar angelenkte Schranktür 24 verschließbar ist und durch welche hindurch ein Innenraum 26 des Kühl- oder Gefriergeräts 10 für den Benutzer zugänglich ist.

Der Innenraum 26 des Kühlschranks 10 kann mit einer breiten Vielfalt von Einbauteilen bestückt oder bestückbar sein, die zum Abstellen und Einlegen von Lebensmitteln geeignet sind. Mindestens eines dieser Einbauteile ist eine Einlegeboden-Baugruppe 28, die als zentralen Bestandteil eine als Fachboden dienende Abstellplatte 30 aufweist, die aus einem lichtdurchlässigen Material, beispielsweise Glas oder Kunststoff, gefertigt sein kann. Die Abstellplatte 30 besitzt einen Rechteckumriss mit Seitenrändern (liegen benachbart zu den Seitenwänden 20), einem hinteren Rand (liegt benachbart zu der Rückwand 18) und einem vorderen Rand (gegenüberliegend zu dem hinteren Plattenrand). Die Einlegeboden-Baugruppe 28 umfasst ferner zwei Halterungselemente 32, von denen jedes im Bereich eines der Seitenränder der Abstellplatte 30 angeordnet ist und von denen in Figur 1 nur eines in gestrichelter Weise angedeutet ist. Die beiden Halterungselemente 32 erstrecken sich jeweils in Längsrichtung des betreffenden Seitenrands der Abstellplatte 30 und ermöglichen es, die Einlegeboden-Baugruppe 28 an geeigneten Halterungsformationen (nicht näher dargestellt), die an den Seitenwänden 20 oder/und der Rückwand 18 des Schrankkorpus 12 vorgesehen sind, aufzulegen oder einzuhaken, um auf diese Weise die Einlegeboden-Baugruppe 28 in dem Innenraum 26 einzuhängen. Die erwähnten Halterungsformationen an den Wänden 18 oder/und 20 des Schrankkorpus 12 können zum Beispiel einen oder mehrere Auflagestifte, eine oder mehrere Einschubschienen, eine oder mehrere Öffnungen zum Einstecken eines Halterungshakens oder dergleichen umfassen, wie dies auf dem hier einschlägigen technischen Gebiet an sich bekannt ist. Die Halterungselemente 32 können sich im wesentlichen über die gesamte Länge der Seitenränder der Abstellplatte 30 erstrecken oder bei anderen Ausgestaltungen kürzer, unter Umständen sogar wesentlich kürzer, als die Seitenränder der Abstellplatte 30 sein.

Im Bereich des vorderen Rands der Abstellplatte 30 weist die Einlegeboden-Baugruppe 28 zudem ein leistenartig längliches Leuchtmodul 34 auf, das sich im wesentlichen über die gesamte Breite der Abstellplatte 30 erstreckt (d.h. von einer der Seitenwände 20 bis zur gegenüberliegenden Seitenwand 20 reicht). Das Leuchtmodul 34 hat Beleuchtungsfunktion für die Abstellplatte 30 oder/und Bereiche des Innenraums 26, die oberhalb oder/und unterhalb der Abstellplatte 30 liegen. Dazu enthält das Leuchtmodul 34 beispielsweise eine Mehrzahl in Leistenlängsrichtung (entsprechend einer Richtung von einer der Seitenwände 20 zur gegenüberliegenden Seitenwand 20) hintereinander angeordneter Lichtquellen (z.B. Leuchtdioden), deren Licht beispielsweise zu einem Teil in die vordere Schmalseite der Abstellplatte 30 eingekoppelt wird und zu einem anderen Teil an der Abstellplatte 30 vorbei in den unterhalb der Abstellplatte 30 liegenden Bereich des Innenraums 26 gelenkt wird. Wegen Einzelheiten einer möglichen Ausgestaltung des Leuchtmoduls 34 wird auf die deutsche Patentanmeldung Nr. 10 2015 007 839.9 verwiesen. Es versteht sich, dass das Leuchtmodul 34 hier nur stellvertretend steht für einen beliebigen elektrischen Verbraucher als Teil der Einlegeboden-Baugruppe 28.

Das Leuchtmodul 34 kann an der Abstellplatte 30 befestigt sein. Alternativ kann das Leuchtmodul 34 an den Halterungselementen 32 befestigt sein. In jedem Fall kann die Einlegeboden-Baugruppe 28 (mit den Komponenten Abstellplatte 30, Halterungselementen 32 und Leuchtmodul 34) als eine Einheit in den Innenraum 26 des Kühl- oder Gefriergeräts 10 eingesetzt und wieder herausgenommen werden.

Im gezeigten Beispielfall enthält das Kühl- oder Gefriergerät 10 mindestens einen weiteren Fachboden 36, der genauso wie die Abstellplatte 30 zum Daraufstellen von Lebensmitteln dient. Wenngleich dies in Figur 1 nicht dargestellt ist, kann der Fachboden 36 Bestandteil einer Einlegeboden-Baugruppe sein, die genauso wie die Einlegeboden-Baugruppe 28 ausgestaltet ist.

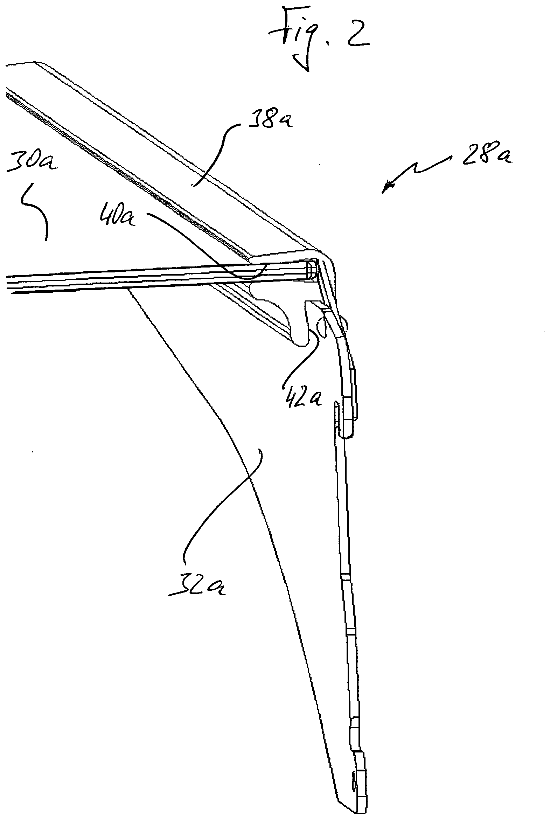

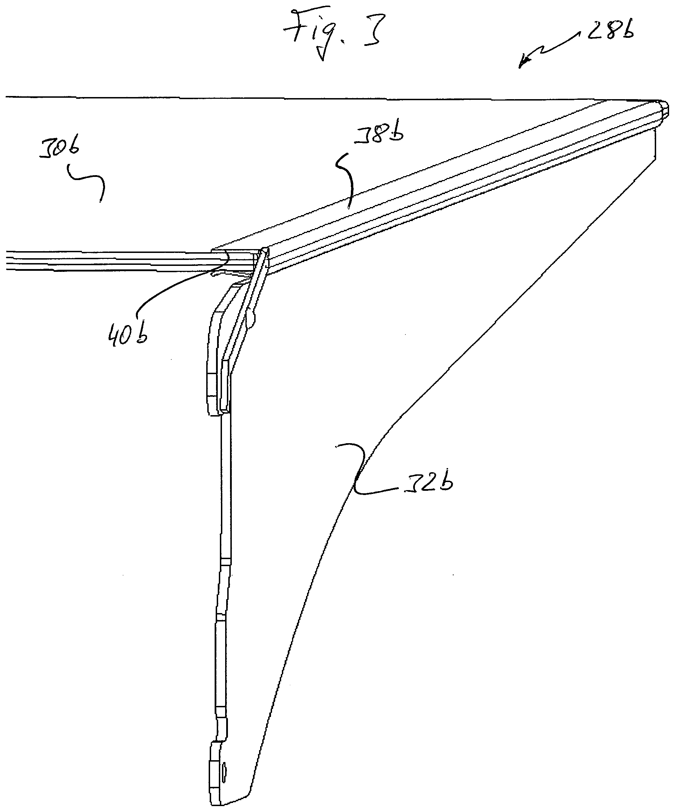

Zur Erläuterung konstruktiver Einzelheiten der Einlegeboden-Baugruppe 28 wird als nächstes auf die Figuren 2 und 3 verwiesen. In diesen beiden Figuren sind zwei Varianten gezeigt, wie eine Verbindung zwischen der Abstellplatte und einem der Halterungselemente der Einlegeboden-Baugruppe realisiert werden kann. In beiden Figuren sind gleiche oder gleichwirkende Komponenten mit gleichen Bezugszeichen wie in Figur 1 bezeichnet, wobei jedoch zur Unterscheidung der beiden Varianten jeweils ein Kleinbuchstabe angehängt ist. Soweit sich nachstehend nichts anderes ergibt, wird zur Erläuterung besagter gleicher oder gleichwirkender Komponenten auf die vorstehenden Ausführungen im Zusammenhang mit der Figur 1 verwiesen.

Figur 2 zeigt einen perspektivischen Blick von schräg hinten auf die Einlegeboden-Baugruppe 28a, d.h. der Blick geht auf die rückseitige Schmalseite der Abstellplatte 30a sowie auf eine der Rückwand 18 des Kühl- oder Gefriergeräts 10 der Fig. 1 zugekehrte Rückseite des Halterungselements 32a. Gleiches gilt für Fig. 3.

Bei der Variante gemäß Figur 2 umfasst die Einlegeboden-Baugruppe 28a eine als Profilteil ausgeführte Verbindungsleiste 38a, die zwei Einsteckschlitze 40a, 42a aufweist. Einer der Einsteckschlitze - hier der Einsteckschlitz 40a - erlaubt es, die Abstellplatte 30a mit einem ihrer Seitenränder voraus in den betreffenden Einsteckschlitz einzuschieben. Der andere Einsteckschlitz - hier der Einsteckschlitz 42a - erlaubt in ähnlicher Weise ein Einstecken eines Randabschnitts des Halterungselements 32a. Die beiden Einsteckschlitze 40a, 42a sind - bei einer Betrachtung in einem Querschnitt zur Leistenlängsrichtung der Verbindungsleiste 38a - im Wesentlichen rechtwinklig zueinander orientiert. Sie besitzen eine Öffnungsweite, die etwas kleiner als die Dicke des in den jeweiligen Einsteckschlitz einzuschiebenden Bereichs der Abstellplatte 30a bzw. des Halterungselements 32a ist, sodass beim Einstecken in den Einsteckschlitz die beiden gegenüberliegenden Schlitzbacken des Einsteckschlitzes etwas auseinandergedrückt werden und die Verbindungsleiste 38 die Abstellplatte 30a und das Halterungselement 32a daher mit Druck festhalten kann. Auf einen zusätzlichen Klebstoff, um die Abstellplatte 30a oder/und das Halterungselement 32a in dem Einsteckschlitz 40a bzw. dem Einsteckschlitz 42a zu verkleben, kann verzichtet werden, wenngleich die Verwendung eines solchen Klebstoff selbstverständlich nicht ausgeschlossen ist. Die Verbindungsleiste 38a ist beispielsweise aus Kunststoff gefertigt, kann aber alternativ aus einem Metall, beispielsweise Aluminium, bestehen.

Bei der Variante gemäß Figur 3 umfasst die Einlegeboden-Baugruppe 28b eine gleichermaßen als Profilteil ausgebildete Verbindungsleiste 38b, die im Unterschied zur Verbindungsleiste 38a der Figur 2 nur einen Einsteckschlitz 40b bildet, der zum Einstecken der Abstellplatte 30b dient. Die Verbindung zwischen der Profilleiste 38b und dem Halterungselement 32b ist beispielsweise durch eine Verklebung, Verschweißung oder Verlötung zwischen beiden Bauteilen realisiert (ohne Steckverbindung). Die Verbindungsleiste 38b ist mithin im fertigen Zustand der Einlegeboden-Baugruppe 28b nicht von dem Halterungselement 32b lösbar.

Auch für die weiteren Figuren gilt, dass dort gleiche oder gleichwirkende Komponenten jeweils mit gleichen Bezugszeichen versehen sind, wiederum ergänzt durch einen Kleinbuchstaben. Soweit sich nachstehend nichts anderes ergibt, wird zur Erläuterung dieser Komponenten auf die vorstehenden Ausführungen verwiesen. Insbesondere können die in den nachfolgenden Figuren gezeigten Ausführungsbeispiele wahlweise mit jeder der beiden in den Figuren 2 und 3 gezeigten Montagevarianten kombiniert werden.

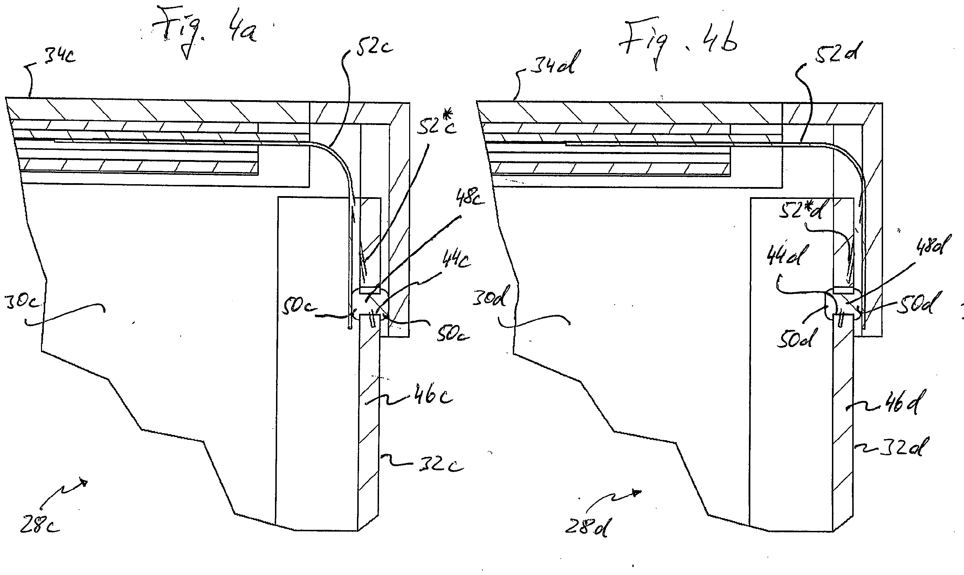

Die in den Figuren 4a bis 9d gezeigten Ausführungsbeispiele gehen davon aus, dass mindestens eines der beiden Halterungselemente 32 der Einlegeboden-Baugruppe 28 gemäß Figur 1 aus einem elektrisch leitenden Metallwerkstoff besteht oder jedenfalls einen solchen Metallwerkstoff enthält und dass dieser Metallwerkstoff genutzt wird, um über das betreffende Halterungselement 32 elektrischen Strom zu dem Leuchtmodul 34 zu leiten. Um elektrischen Strom leiten zu können, weisen die Halterungsmodule 32 beispielsweise einen aus Aluminium, Eisen oder Stahl bestehenden Metallkern auf, der von einer elektrisch isolierenden Beschichtung oder Umhüllung umschlossen ist. Um einen elektrischen Kontakt zu dem betreffenden Halterungselement 32 herzustellen, muss deshalb diese Beschichtung oder Umhüllung, die beispielsweise von einer Pulverlackierung oder einer Eloxal-Schicht gebildet ist, durchdrungen werden. Hierzu ist in dem betreffenden Halterungselement mindestens ein Ausschnitt vorgesehen, der durch Bohren oder Stanzen in ein - bereits mit der Beschichtung oder Umhüllung versehenes - Vorprodukt des fertigen Halterungselements 32 eingebracht wird und an dessen Innenwand der Kontakt zu einem elektrisch leitenden Element hergestellt ist, das aus dem Ausschnitt herausreicht. Es versteht sich, dass der Ausschnitt dort in das betreffende Halterungselement 32 eingebracht ist, wo der Metallkern vorhanden ist und dementsprechend an der Innenwand des Ausschnitts der Metallwerkstoff des Halterungselements 32 frei zugänglich ist. Verschiedene Ausführungsbeispiele, um auf diese Weise eine elektrische Kontaktierung des Halterungselements 32 vorzunehmen, sind in den Figuren 4a bis 9d gezeigt.

Bei dem Ausführungsbeispiel gemäß Figur 4a weist das Halterungselement 32c einen Ausschnitt 44c in Form einer Durchgangsbohrung mit Kreisquerschnitt auf, die in einem Wandstück 46c des Halterungselements 32c vorgesehen ist und dieses Wandstück 46c auf dessen gesamter Wanddicke durchsetzt. In den Ausschnitt 44c ist ein Niet 48c eingesetzt, der ebenfalls aus einem elektrisch leitenden Material besteht, beispielsweise Kupfer, Nickel, Zink, Eisen oder einer Legierung mit einem oder mehreren dieser Materialien, und Nietköpfe 50c aufweist. Die Nietköpfe 50c befinden sich außerhalb des Ausschnitts 44c; innerhalb des Ausschnitts 44c besteht ein elektrischer Kontakt zwischen der Außenumfangsfläche des Niets 48c und der Innenumfangsfläche des Ausschnitts 44c.

Aus dem Leuchtmodul 34c steht ein weiterer elektrischer Leiter 52c heraus, der auf einem der Nietköpfe 50c des Niets 48c aufliegt und hierdurch eine elektrische Verbindung zu dem Niet 48c und damit dem Halterungselement 32c herstellt. Um einen dauerhaft sicheren Kontakt zwischen dem Leiter 52c und dem Niet 48c zu gewährleisten, sollte der Leiter 52c unter Krafteinwirkung an dem Niet 48c anliegen. Dies kann dadurch realisiert werden, dass der Leiter 52c von einem aus Metallblech gefertigten Winkelstück gebildet ist, das im fertig montierten Zustand der Einlegeboden-Baugruppe 28c unter Eigenfederspannung gegen den Niet 48c drückt. Bei 52*c ist diesbezüglich in Figur 4a mit unterbrochenen Strichen die Form des Leiters 52c vor Einbau in die Einlegeboden-Baugruppe 28c angedeutet. Beim Zusammenbau der Einlegeboden-Baugruppe 28c wird der Leiter 52c elastisch verbogen, wodurch die für den gewünschten sicheren elektrischen Kontakt erforderliche Eigenfederspannung erzeugt wird.

Statt des Niets 48c kann beispielsweise auch eine Schraube (z.B. Blechschraube aus Zink) verwendet werden, die in den Ausschnitt 44c eingeschraubt wird und an ihrem Schraubenkopf von dem Leiter 52c kontaktiert wird.

Im Beispielfall der Figur 4a liegt der Leiter 52c an einem der Abstellplatte 30c näher gelegenen der beiden Nietköpfe 50c an. Es ist selbstverständlich auch die umgekehrte Situation vorstellbar, bei welcher der Leiter 52c an einem von der Abstellplatte 30c entfernt gelegenen der Nietköpfe 50c anliegt. Diese Situation ist in Figur 4b dargestellt. Bei der Variante gemäß Figur 4b erstreckt sich der Leiter 52d außerhalb des Wandstücks 46d (gesehen von der Abstellplatte 30d), nicht innerhalb wie bei der Variante gemäß Figur 4a.

Bei dem Ausführungsbeispiel gemäß Figur 5 ist ein unmittelbarer elektrischer Kontakt zwischen dem Halterungselement 32e und dem Leiter 52e dadurch hergestellt, dass ein freies Ende des Leiters 52e in den Ausschnitt 44e hineinragt und dort zwischen dem Niet 48e und der Innenumfangsfläche des Ausschnitts 44e eingeklemmt ist. Der Leiter 52e ist in diesem Fall beispielsweise von einem biegsamen Draht gebildet, dessen in den Ausschnitt 44e hineinragender Endabschnitt von einer Drahtisolierung befreit ist.

Bei dem Ausführungsbeispiel gemäß den Figuren 6a, 6b ist der Leiter 52f von einem biegsamen oder unbiegsamen Drahtstück gebildet, das mit einem Endabschnitt in den Ausschnitt 44f eingesetzt ist, wobei ein aus dem Ausschnitt 44f herausstehender Teil des Drahtstücks 52f zu einem Nietkopf 54f geformt ist. Das Drahtstück 52f kann den Nietkopf 54f bereits aufweisen, wenn es für den Zusammenbau der einzelnen Komponenten der Einlegeboden-Baugruppe 28f angeliefert wird. Alternativ kann der Nietkopf 54f mittels eines Nietsetzers durch plastische Verformung des Drahtstücks 52f erzeugt werden, nachdem das Drahtstück 52f durch den Ausschnitt 44f hindurchgesteckt wurde.

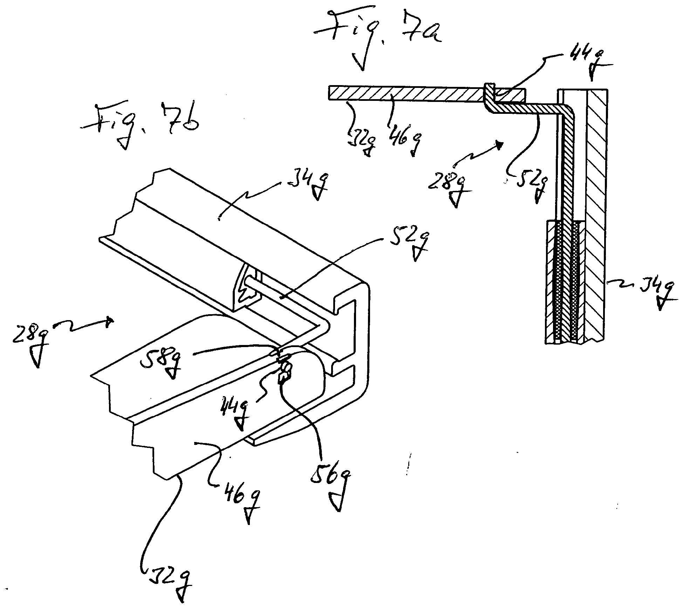

Bei dem Ausführungsbeispiel gemäß den Figuren 7a, 7b ist der Leiter 52g wiederum von einem biegsamen oder unbiegsamen Drahtstück mit Kreisquerschnitt gebildet, das in den Ausschnitt 44g hineingesteckt ist und - im gezeigten Beispielfall - durch den Ausschnitt 44g hindurchragt. Zur Fixierung des in dem Ausschnitt 44g befindlichen Endabschnitts des Drahtstücks 52g ist der Ausschnitt 44g durch Quetschung verengt. Beispielsweise kann mittels eines Zangen- oder anderen Werkszeugs von zwei gegenüberliegenden Seiten des Ausschnitts 44g her eine Quetschung des den Ausschnitt 44g enthaltenden Teils des Halterungselements 32g bewirkt werden. Hierzu ist in Figur 7b beispielhaft ein Durchbruch 56g in dem Halterungselement 32g angedeutet. In diesem Durchbruch 56g kann eine Quetschbacke des erwähnten Quetschwerkzeugs eingeführt werden, während die andere Quetschbacke auf der gegenüberliegenden Seite des Ausschnitts 44g an dem Halterungselement 32g (in Figur 7b bei 58g) angreift.

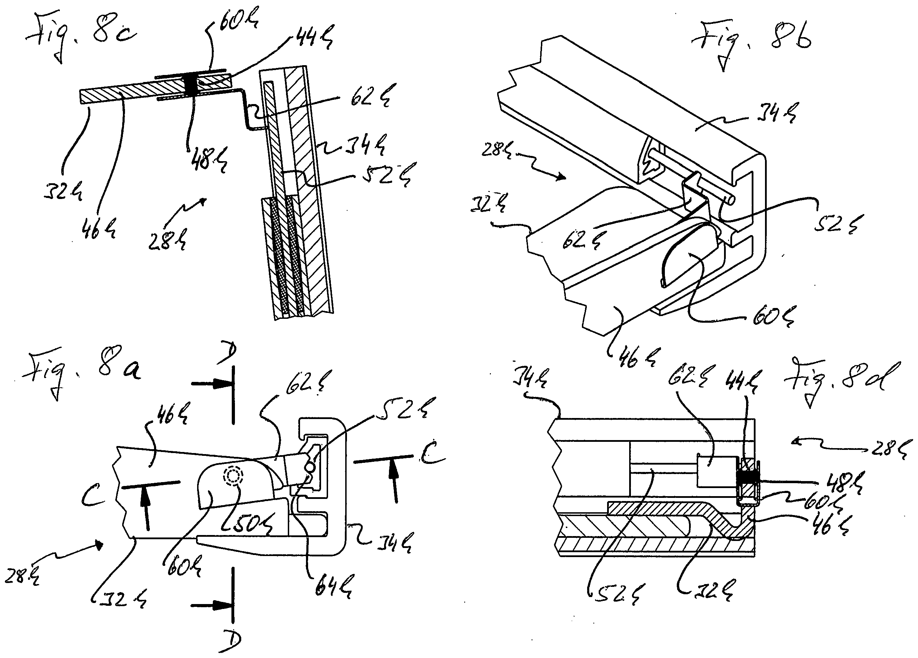

Es wird nun auf das Ausführungsbeispiel gemäß den Figuren 8a bis 8d verwiesen. Von diesen stellt Figur 8c einen Schnitt längs einer Linie C-C in Figur 8a dar, während Figur 8d einen Schnitt längs einer Linie D-D in Figur 8a darstellt.

Die elektrische Kontaktierung des Halterungselements 32h ist bei dem Ausführungsbeispiel gemäß den Figuren 8a bis 8d - ähnlich wie bei den Ausführungsbeispielen der Figuren 4a, 4b - durch einen Niet 48h bewirkt, der in den Ausschnitt 44h des Halterungselements 32h eingesetzt ist. Ein elektrisch leitendes Zwischenstück 62h ist als Blech-Biegeteil (z. B. verzinkt, versilbert oder aus Kupfer) ausgeführt und weist einen U-förmig gebogenen Abschnitt 60h auf, der so auf einen Teil des Wandabschnitts 46h aufgesteckt ist, dass die beiden seitlichen Schenkel des U-Abschnitts 60h den Niet 48h an dessen beiden Nietköpfen 50h kontaktieren. Dies ist gut in den Figuren 8c, 8d erkennbar. Zum Leuchtmodul 34h hin steht das Zwischenstück 62h mit einem aus dem Leuchtmodul 34 herausragenden stabförmigen Leiterelement 52h in Stromübertragungskontakt. Dieser ist im gezeigten Beispielfall mittels einer Einkerbung 64h (Figur 8a) des Zwischenstücks 62h hergestellt, in welche das Leiterelement 52h eingreift. Zweckmäßigerweise drückt das Zwischenstück 62h unter Eigenfederspannung gegen das Leiterelement 52h, um einen guten elektrischen Kontakt zu verwirklichen. Alternativ oder zusätzlich kann das Zwischenstück 62h mit dem Leiterelement 52h fest verbunden sein, etwa durch Verlötung oder durch eine Crimpverbindung.

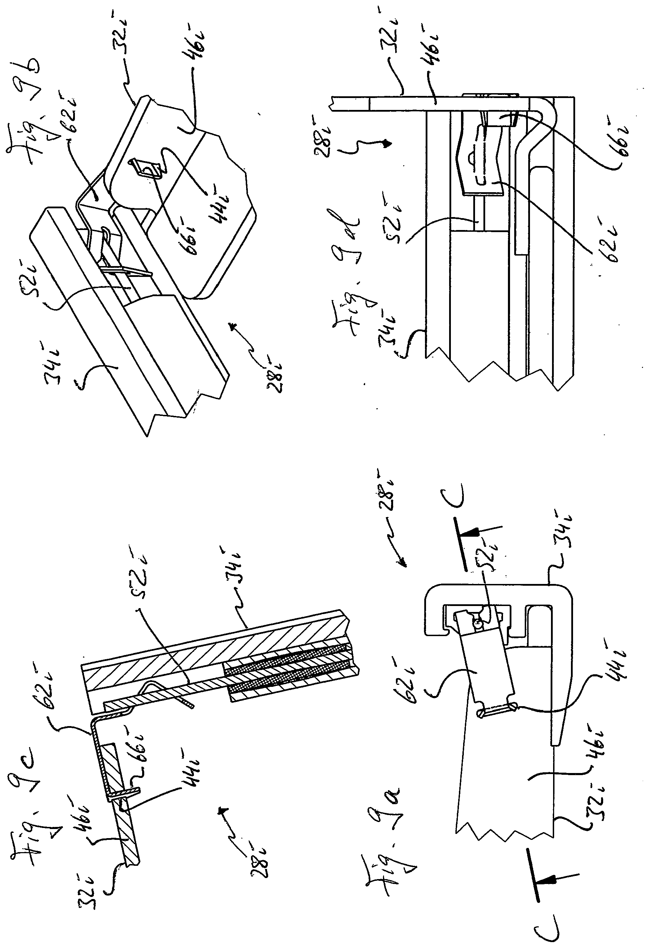

Es wird nun auf das Ausführungsbeispiel gemäß den Figuren 9a bis 9d verwiesen. Hierbei zeigt Figur 9c eine Schnittansicht längs eine Schnittlinie C-C in Figur 9a.

Im Unterschied zu den vorhergehend gezeigten Ausführungsbeispielen ist bei dem Ausführungsbeispiel gemäß den Figuren 9a bis 9d der Ausschnitt 44i nicht als kreisförmiges Durchgangsloch ausgeführt, sondern als das Wandstück 46i des Halterungselements 32i durchsetzendes Schlitzloch. In dieses Schlitzloch 44i ist eine Endzunge 66i eines elektrisch leitenden, aus Blechmaterial gefertigten Winkelteils 62i eingesetzt, das seinerseits mit einem stabförmigen Leiterelement 52i des Leuchtmoduls 34i in stromübertragendem Kontakt steht. Im fertig montierten Zustand der Einlegeboden-Baugruppe 28i ist das Winkelteil 62i im elastischen Bereich gebogen, sodass es unter einer Eigenfederspannung steht, durch die sowohl am Übergang zum Halterungselement 32i als auch am Übergang zu dem Leiterelement 52i ein guter mechanischer und damit elektrischer Kontakt sichergestellt wird.

Bei allen der hier vorgestellten Ausführungsbeispielen kann erreicht werden, dass die nach Erzeugung des Ausschnitts in dem Halterungselement freigelegte Metalloberfläche innerhalb des Ausschnitts durch den anschließenden Eingriff eines elektrisch leitenden Elements im Wesentlichen vollständig gegenüber der Außenumgebung verschlossen bzw. abgedeckt wird. Aus diesem Grund kann für den Metallwerkstoff des Halterungselements beispielsweise Eisen (anstatt eines hochlegierten, nichtrostenden Edelstahls) verwendet werden, ohne dass Korrosion des Eisenmaterials befürchtet werden muss.

## Patentansprüche

1. Einlegeboden-Baugruppe (28) für ein Kühl- oder Gefriergerät (10), umfassend:
- eine Abstellplatte (30) zum Abstellen von Gegenständen,
- eine mit der Abstellplatte zu einer Baueinheit zusammengefügte Halterungsanordnung, mittels welcher die Einlegeboden-Baugruppe in einem Kühl- oder Gefrierraum (26) des Kühl- oder Gefriergeräts an Begrenzungswänden (18, 20) des Kühl- oder Gefrierraums aufhängbar ist, wobei die Halterungsanordnung mindestens ein im Bereich eines Seitenrands der Abstellplatte angeordnetes, sich längs des Seitenrands erstreckendes und zumindest teilweise aus einem elektrisch leitenden Metallwerkstoff gefertigtes Halterungselement (32) aufweist, wobei das Halterungselement einen Metallkern aufweist, der eine Beschichtung oder Umhüllung aus einem elektrisch isolierenden Material aufweist,
- einen elektrischen Verbraucher (34), wobei die Einlegeboden-Baugruppe einen über den Metallwerkstoff des Halterungselements führenden Stromversorgungspfad zur Stromversorgung des Verbrauchers bildet und in dem Stromversorgungspfad ein elektrisch leitendes Element liegt, welches in einen in das Halterungselement eingebrachten, die Beschichtung oder Umhüllung durchdringenden Ausschnitt (44c; 44e) in dem Halterungselement hineinragt und dort in elektrisch leitendem Kontakt mit dem Metallkern des Halterungselements steht,
**dadurch gekennzeichnet, dass** das elektrisch leitende Element ein in den Ausschnitt (44c) eingesetzter Bolzenkörper (48c) mit einem aus dem Ausschnitt herausstehenden Bolzenkopf (50c) ist, wobei ein weiteres in dem Stromversorgungspfad liegendes elektrisch leitendes Element auf dem Bolzenkopf aufliegt oder zwischen dem Halterungselement (32) und dem Bolzenkopf eingeklemmt ist,
oder dass das elektrisch leitende Element durch Quetscheingriff in dem Ausschnitt (44e) gehalten ist.

2. Einlegeboden-Baugruppe (28) nach Anspruch 1, wobei das weitere lektrisch leitende Element auf dem Bolzenkopf unter Federvorspannung aufliegt.

3. Einlegeboden-Baugruppe (28) nach Anspruch 1 oder 2, wobei der Bolzenkörper ein Niet oder eine Schraube ist.

4. Einlegeboden-Baugruppe (28) nach Anspruch 1, wobei das elektrisch leitende Element zwischen gegenüberliegenden Abschnitten einer Innenwand des Ausschnitts eingequetscht ist oder zwischen der Innenwand des Ausschnitts und einem in den Ausschnitt eingesetzten, insbesondere elektrisch leitenden Bolzenkörper (48e), beispielsweise einem Niet, eingequetscht ist.

5. Einlegeboden-Baugruppe (28) nach Anspruch 4, wobei das elektrisch leitende Element ein Drahtstück (52f) ist, wobei das Drahtstück beispielsweise durch den Ausschnitt hindurchreicht und im Bereich eines aus dem Ausschnitt herausstehenden Endabschnitts zu einem Nietkopf (54f) geformt ist.

6. Einlegeboden-Baugruppe (28) nach einem der Ansprüche 1 bis 5, wobei der Ausschnitt als Sack- oder Durchgangsloch mit Kreisquerschnitt ausgeführt ist oder Schlitzform besitzt.

7. Einlegeboden-Baugruppe (28) nach einem der Ansprüche 1 bis 6, wobei der Metallwerkstoff des Halterungselements (32) Aluminium, Eisen oder Stahl, beispielsweise ein niedriglegierter Stahl, ist.

8. Einlegeboden-Baugruppe (28) nach einem der Ansprüche 1 bis 7, wobei der Metallwerkstoff des Halterungselements (32) frei von einem hochlegierten Stahl ist.

9. Einlegeboden-Baugruppe (28) nach einem der Ansprüche 1 bis 8, wobei der Verbraucher (34) im Bereich eines Vorderrands der Abstellplatte (30) montiert ist und das elektrisch leitende Element in dem Stromversorgungspfad zwischen dem Halterungselement (32) und dem Verbraucher liegt.

10. Einlegeboden-Baugruppe (28) nach einem der Ansprüche 1 bis 9 oder nach dem Oberbegriff des Anspruchs 1, wobei die Halterungsanordnung eine Verbindungsleiste (38a) in Zuordnung zu dem Halterungselement (32) umfasst, wobei die Verbindungsleiste einen Einsteckschlitz (40a) aufweist, in welchen die Abstellplatte mit einem Seitenrandabschnitt eingesteckt ist, wobei optional die Verbindungsleiste einen weiteren Einsteckschlitz (42a) aufweist, in welchen das Halterungselement eingesteckt ist.

11. Verfahren zur Herstellung einer Einlegeboden-Baugruppe (28) nach einem der vorhergehenden Ansprüche, wobei bei dem Verfahren der Ausschnitt (44c, 44e) durch Bohren oder Stanzen eines den Metallkern sowie die Beschichtung oder Umhüllung aufweisenden Vorprodukts des Halterungselements (32) gebildet wird.

12. Verfahren nach Anspruch 11, wobei zur Bildung des Ausschnitts (44c, 44e) durch die Beschichtung oder Umhüllung hindurch in den Metallkern hinein und gewünschtenfalls durch diesen hindurch gebohrt oder gestanzt wird.

13. Verfahren nach Anspruch 12, wobei die Beschichtung oder Umhüllung eine Eloxal-Beschichtung, eine Pulverlackierung oder eine Kunststoffeinbettung des Metallkerns umfasst.

## Claims

1. A shelf assembly (28) for a refrigerator or freezer (10), comprising:
a receiving plate (30) for receiving objects;
a holding arrangement, which is joined to the receiving plate to form a structural unit, and by means of which the shelf assembly can be mounted in a cooling or freezing space (26) of the refrigerator or freezer on delimiting walls (18, 20) of the cooling or freezing space, wherein the holding arrangement includes at least one holding element (32), which is arranged in the region of a side edge of the receiving plate, extends along the side edge and is made at least in part of an electrically conducting metal material, wherein the holding element has a metal core, which has a coating or casing of an electrically insulating material,
an electrical consumer (34), wherein the shelf assembly forms a power supply path extending via the metal material of the holding element for supplying power to the electrical consumer, and an electrically conducting element is located in the power supply path, which electrically conducting element projects into a cutout (44c; 44e) created in the holding element and is in electrically conducting contact with the metal core of the holding element there,
**characterized in that** the electrically conducting element is a bolt member (48c), which is inserted into the cutout (44c) and has a bolt head (50c) protruding out of the cutout, wherein another electrically conducting element located in the power supply path rests on the bolt head or is clamped between the holding element (32) and the bolt head,
or the electrically conducting element is held in the cutout (44e) by squeeze engagement.

2. The shelf assembly (28) according to claim 1, wherein the further electrically conducting element rests on the bolt head under spring tension.

3. The shelf assembly (28) according to claim 1 or 2, wherein the bolt member is a rivet or a screw.

4. The shelf assembly (28) according to claim 1, wherein the electrically conducting element is squeezed between opposing portions of an inside wall of the cutout or is squeezed between the inside wall of the cutout and a bolt member (48e), for example, a rivet.

5. The shelf assembly (28) according to claim 4, wherein the electrically conducting element is a wire member (52f), wherein the wire member extends through the cutout, for example, and is shaped into a rivet head (54f) in the region of an end portion protruding out of the cutout.

6. The shelf assembly (28) according to any one of claims 1 to 5, wherein the cutout is in the form of a blind hole or a through-hole of a circular cross-section or is in the form of a slot.

7. The shelf assembly (28) according to any one of claims 1 to 6, wherein the metal material of the holding element (32) is aluminum, iron or steel, for example, a low-alloy steel.

8. The shelf assembly (28) according to any one of claims 1 to 7, wherein the metal material of the holding element (32) is free of any high-alloy steel.

9. The shelf assembly (28) according to any one of claims 1 to 8, wherein the consumer (34) is mounted in the region of a front edge of the receiving plate (30), and the electrically conducting element is located in the power supply path between the holding element (32) and the consumer.

10. The shelf assembly (28) according to any one of claims 1 to 9 or according to the preamble of claim 1, wherein the holding arrangement comprises a connecting strip (38a) in association with the holding element (32), wherein the connecting strip has an insertion slot (40a), into which the receiving plate is inserted with a side edge portion, wherein the connecting strip optionally has an additional insertion slot (42a) into which the holding element is inserted.

11. A method for producing a shelf assembly (28) according to any one of the preceding claims, wherein the cutout (44c; 44e) is formed in this method by drilling or punching a pre-product of the holding element (32) comprising the metal core and the coating or the casing.

12. The method according to claim 11, wherein the cutout (44c; 44e) is formed by drilling or punching into and optionally through the metal core.

13. The method according to claim 12, wherein the coating or casing comprises an anodic coating or a powder coating on the metal core or embedding the metal core in plastic.

## Revendications

1. Ensemble d'étagère (28) pour un réfrigérateur ou un congélateur (10), comprenant :
- une plaque de réception (30) pour recevoir des objets,
- un dispositif de support joint à la plaque de réception pour former une unité structurelle, au moyen duquel l'ensemble d'étagère peut être suspendu dans un espace de réfrigération ou de congélation (26) du réfrigérateur ou du congélateur sur les parois (18, 20) délimitant l'espace de réfrigération ou de congélation, le dispositif de support comprenant au moins un élément de support (32) qui est disposé dans la région d'un bord latéral de la plaque de réception, s'étend le long du bord latéral et est au moins partiellement constitué d'un matériau métallique électriquement conducteur, l'élément de support présentant un noyau métallique qui comporte un revêtement ou une enveloppe en un matériau électriquement isolant,
- un consommateur électrique (34), l'ensemble d'étagère formant un chemin d'alimentation électrique passant par le matériau métallique de l'élément de support pour fournir de l'énergie au consommateur, et un élément électriquement conducteur se trouvant dans le chemin d'alimentation électrique, lequel élément fait saillie dans l'élément de support dans une découpe (44c ; 44e) pratiquée dans l'élément de support qui pénètre dans le revêtement ou le boîtier (44c; 44e) et est en contact de manière électriquement conductrice avec le noyau métallique de l'élément de support,
**caractérisé en ce que** l'élément électriquement conducteur est un corps de boulon (48c) inséré dans la découpe (44c) avec une tête de boulon (50c) dépassant de la découpe, un autre élément électriquement conducteur se trouvant dans le chemin d'alimentation électrique reposant sur la tête de boulon ou étant serré entre l'élément de support (32) et la tête du boulon,
ou **en ce que** l'élément électriquement conducteur est maintenu dans la découpe (44e) par engagement de sertissage.

2. Ensemble d'étagère (28) selon la revendication 1, dans lequel l'autre élément électriquement conducteur repose sur la tête de boulon par tension de ressort.

3. Ensemble d'étagère (28) selon les revendications 1 ou 2, dans lequel le corps de boulon est un rivet ou une vis.

4. Ensemble d'étagère (28) selon la revendication 1, dans lequel l'élément électriquement conducteur est pincé entre des sections opposées d'une paroi intérieure de la découpe ou entre la paroi intérieure de la découpe et un corps de boulon particulièrement conducteur électriquement (48e), par exemple un rivet, inséré dans la découpe.

5. Ensemble d'étagère (28) selon la revendication 4, dans lequel l'élément électriquement conducteur est un morceau de fil (52f), le morceau de fil s'étendant, par exemple, à travers la découpe et étant façonné en une tête de rivet (54f) dans la région d'une section d'extrémité dépassant de la découpe.

6. Ensemble d'étagère (28) selon l'une quelconque des revendications 1 à 5, dans lequel la découpe est conçue comme un trou borgne ou traversant avec une section transversale circulaire, ou a une forme de fente.

7. Ensemble d'étagère (28) selon l'une quelconque des revendications 1 à 6, dans lequel le matériau métallique de l'élément de support (32) est de l'aluminium, du fer ou de l'acier, par exemple un acier faiblement allié.

8. Ensemble d'étagère (28) selon l'une quelconque des revendications 1 à 7, dans lequel le matériau métallique de l'élément de support (32) est exempt d'un acier fortement allié.

9. Ensemble d'étagère (28) selon l'une quelconque des revendications 1 à 8, dans lequel le consommateur (34) est monté dans la région d'un bord avant de la plaque de réception (30) et l'élément électriquement conducteur se trouve dans le chemin d'alimentation électrique entre l'élément de support (32) et le consommateur.

10. Ensemble d'étagère (28) selon l'une quelconque des revendications 1 à 9 ou selon le préambule de la revendication 1, dans lequel le dispositif de support comprend une barre de connexion (38a) en association avec l'élément de support (32), la barre de connexion ayant une fente d'insertion (40a) dans laquelle la plaque de réception est insérée avec une section de bord latéral, la barre de connexion ayant éventuellement une autre fente d'insertion (42a) dans laquelle l'élément de support est inséré.

11. Procédé de fabrication d'un ensemble d'étagères (28) selon l'une quelconque des revendications précédentes, dans lequel dans le procédé, la découpe (44c, 44e) est formée par perçage ou poinçonnage d'un produit intermédiaire de l'élément de support (32) qui présente le noyau métallique et le revêtement ou l'enveloppe.

12. Procédé selon la revendication 11, dans lequel pour former la découpe (44c, 44e) à travers le revêtement ou l'enveloppe, on perce ou poinçonne dans le noyau métallique et éventuellement à travers celui-ci.

13. Procédé selon la revendication 12, dans lequel le revêtement ou l'enveloppe est un revêtement anodisé, un revêtement pulvérulent ou un enrobage plastique du noyau métallique.
